(19) Europäisches Patentamt
European Patent Office
Office européen des brevets

(11) **EP 3 021 366 A1**

(12) **EUROPEAN PATENT APPLICATION**

(43) Date of publication:
**18.05.2016 Bulletin 2016/20**

(51) Int Cl.:
*H01L 31/0747* (2012.01)   *H01L 31/18* (2006.01)
*H01L 31/068* (2012.01)   *H01L 31/0224* (2006.01)

(21) Application number: **14306825.2**

(22) Date of filing: **17.11.2014**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**

(71) Applicants:
• **TOTAL MARKETING SERVICES**
  **92800 Puteaux (FR)**

• **Ecole Polytechnique**
  **91120 Palaiseau (FR)**
• **Centre National de la Recherche Scientifique**
  **75016 Paris (FR)**

(72) Inventor: **Sobkowicz, Igor**
  **75014 Paris (FR)**

(74) Representative: **Coralis Harle**
  **14-16 Rue Ballu**
  **75009 Paris (FR)**

(54) **Solar cell and method of manufacturing thereof**

(57) The present invention concerns a solar cell (300) comprising a substrate (1) comprising a crystalline semiconductor material having at least one randomly textured surface (102, 103), a layer (16, 17) of intrinsic hydrogenated amorphous silicon for passivating said randomly textured surface (102, 103), and a layer (14, 15) of intrinsic hydrogenated amorphous carbide-silicon alloy on said textured surface (102, 103) between said randomly textured surface and said layer (16, 17) of intrinsic hydrogenated amorphous silicon.

Fig.3

## Description

## Technical Field

The present invention relates to the manufacturing of photovoltaic (or PV) cells, optoelectronic or microelectronic devices. More specifically, the invention relates to high conversion efficiency homojunction or heterojunction solar cells. The invention relates in general to the passivation of textured crystalline silicon (c-Si).

## Background

Over the past twenty years, the development of silicon-based high efficiency solar cells has attracted more and more attention.

Among the different architectures available, silicon homojunctions and heterojunctions (SHJ) allow reaching high efficiencies, close to 25% today, mostly on the lab scale. On production lines however, it is possible to obtain efficiencies close to 23%. In such devices, it is required to reduce losses induced by photogenerated charge carrier neutralization or recombination, by depositing a passivating layer, often on both sides of the substrates.

Many materials can be used to passivate the c-Si surface, such as $SiO_2$ or $SiN_x$. An efficient way to passivate the c-Si surface is to use a layer of hydrogenated amorphous silicon (a-Si:H), which has good passivating properties, due to its high hydrogen content and wide bandgap (~1.7eV) but which also can be deposited at a relatively low temperature compared to other passivating materials. When doped with opposite charges, the c-Si substrate and the $\alpha$-Si:H layer can form a pn junction and constitute the core a SHJ solar cell. In the case of an Interdigitated Back Contact-heterojunction with intrinsic thin-layer (IBC-HIT) solar cell structure, this $\alpha$-Si:H layer can remain undoped since charge carriers do not have to flow through the front side and its role is only to repell the carriers approaching the interface of the pn junction. Similarly, in the case of homojunctions, the front surface needs to be passivated to reduce recombination, and the deposition of a-Si:H can again fulfill this role of passivating layer. In a more general way, when passivation of a c-Si substrate is required to lower recombinations, a-Si:H can be deposited, doped or undoped, depending on whether it is needed to collect charge carriers through the passivating layer or not.

The first PV cells were based on flat crystalline substrates, for example double-side polished c-Si wafers. The surface of a flat c-Si wafer has generally a <100> crystallographic orientation.

In the case of SHJ solar cells, the efficiency of the current collection depends in particular on the quality of the interface between the c-Si substrate and the a-Si:H layer, which form a p-n electronic junction. Generally speaking, defects at the interfaces of an electronic junction device may induce recombination of charge carriers, thus reducing the current collected at the electrodes. High bulk and/or surface recombinations are known to limit the open circuit voltage and to reduce the fill factor of heterojunction solar cell devices. Reduction of surface recombination by a surface passivation technique is necessary to obtain high efficiency solar cells.

Surface passivation of crystalline silicon (c-Si) enables to neutralize chemically and physically the unsaturated dangling bonds at the crystalline silicon surface. Surface passivation generally consists in depositing a thin layer of a material which neutralizes the dangling bonds between the substrate and another semiconductor material, and which separates charge carriers of opposite signs by a field-effect induced by an energy bandgap mismatch which can be enhanced by the presence of charges (by doping for example).

Different materials can be used for surface passivation of flat c-Si of <100> crystallographic orientation. Most of these passivation materials are amorphous. Thermally grown silicon dioxide ($SiO_2$) is commonly used for surface passivation of polished <100> c-Si. However, the temperature required for thermal oxidation is usually above 1000 °C, which implies high manufacturing costs. Other materials can be deposited by plasma enhanced chemical vapor deposition (PECVD) at low temperature, generally below 400°C or even below 200°C. For example, silicon nitride (SiNx) provides a passivation layer. Stacks combining $SiO_2$ and SiNx can also be used. Hydrogenated amorphous silicon (a-Si:H) also enables surface passivation of c-Si. Recently, deposition of a 40-100 nm thick hydrogenated amorphous silicon-carbide a-$SiC_x$:H layer has also been proposed for surface passivation of c-Si. However, stabilization of the a-$SiC_x$:H layer required annealing at a temperature of 730°C. Moreover, the introduction of a silicon oxide, silicon nitride or silicon carbide layer increases the resistivity of the material.

Solar cells with a passivation layer consisting of an intrinsic hydrogenated amorphous silicon (a-Si:H (i)) interface passivating layer are known to have a high open-circuit voltage and to provide the highest conversion efficiency among silicon-based solar cells, manufactured at a low temperature, generally below 200°C.

Passivation using a hydrogenated amorphous silicon layer combines two features. The atomic hydrogen of a-Si:H passivates the broken dangling bonds at the c-Si surface and thus lowers the defect density at the passivating layer/c-Si substrate interface. Moreover, a-Si:H has a bandgap of 1.7 eV (which can be tuned up to values close to 2 eV by adding some impurities) that is wider than the c-Si bandgap of 1.12 eV, thus generating a band-offset. Thus, covering the bare parts of a silicon substrate with a-Si:H enables to passivate the reactive dangling bonds on the surface and lower the recombination probability within the device thanks to the band offset.

In heterojunction solar cells, since the charge carriers must cross the interface to be collected at both ends (front grid and back contact), both sides of the wafer must be passivated.

In homojunction solar cells, metallic electrodes collect charge carriers on parts of the surface of the substrate. However, due to the high diffusion lengths of electrons and holes in crystalline silicon, any remaining dangling bond on uncovered silicon substrate surface contributes to surface recombination process. Thus, in homojunction devices it is also necessary to passivate any surface of the silicon substrate which is not covered by the electrodes. This is also the case for the interdigitated back-contact (IBC) architecture, either homojunction or heterojunction. The front side must be passivated to avoid any losses due to recombination, and in the back, the bare parts of the wafer also. Thus, passivation is equally important in heterojunction and homojunction solar cells, both in the front contact and IBC structures.

Surface passivation of bare parts of crystalline silicon in heterojunction or homojunction devices is thus used in the fabrication of electronic devices such as transistors and photovoltaic solar cells, for enhancing conversion efficiency.

The limited conversion efficiency of PV cells is also due to optical losses by reflection of the incoming light at the front and/or at the backside of a heterojunction device.

For these applications, it is beneficial to texture the surface of the c-Si substrate. In the present document, texturing the surface of a material means generally etching microstructures into the surface of the material.

Surface texturing of a crystalline silicon substrate allows obtaining a randomly textured surface, wherein the crystalline silicon surface is textured with microstructures having spatial dimensions and/or positions which are randomly distributed, such as randomly distributed pyramids for example. Randomly textured silicon substrates enable to increase light trapping inside a PV cell, by decreasing the surface reflectivity and by increasing coupling into the cell of the light that usually escapes. Therefore, more photons are collected on a same PV cell area.

Different techniques for randomly texturing a crystalline semiconductor surface exist which comprise in particular anisotropic wet-etching and dry-etching techniques.

Anisotropic wet-etching consists in applying a chemical solution that chemically etches the semiconductor surface with higher etching rate along some crystallographic directions than others. Many silicon surface texturing approaches are based on anisotropic wet-etching using alkaline solutions such as sodium hydroxide (NaOH), potassium hydroxide (KOH) or other hydroxides of alkaline metals as well as alkaline-free solutions such as TMAH (tetramethyl ammonium hydroxide). The application of anisotropic wet-etching to initially flat <100> crystalline silicon produces randomly distributed microstructures at the surface of the silicon substrate and exposes <111> planes in silicon. In certain operating conditions, these microstructures have a pyramid or an inverted-pyramid shape. The facets of the pyramids generally have a close to perfect <111> plane crystallographic orientation. These pyramids are said randomly distributed when their bases have random dimensions, generally comprised between 1 and 10 microns. Industrial production of monocrystalline silicon solar cells is mainly based on random pyramidal structures featuring <111> oriented facets.

However, some imperfections may be present at the surface of a randomly textured silicon surface, which exhibit different crystallographic orientations than the <111> orientation of the facets. The crystallographic orientation of these imperfections is not well known and may include a distribution of planes of different crystallographic orientations between the <111> and <100> crystallographic orientations. Generally, most of the surface of a randomly textured c-Si substrate consists in facets of <111> crystallographic orientation.

Randomly texturing crystalline silicon surface by dry etching, for example by plasma etching, may produce different surface textures, with different shapes of microstructures, different spatial distribution of the microstructures and/or different crystallographic orientations of these microstructures.

Other dry etching techniques, such as nanoimprint, enable production of periodic microstructures which do not exhibit a random distribution.

Passivation of randomly textured substrates is more complex than passivation of flat c-Si substrates due to the larger developed surface and to the presence of the above-mentioned imperfections. Moreover, one-to-one transfer of passivation process parameters from flat to textured c-Si is not necessarily appropriate. For example, under some conditions, the same operating PECVD conditions used for the deposition of a-Si:H can result in the growth of epitaxial or microcrystalline silicon on a <100> oriented c-Si surface and respectively in the growth of amorphous silicon on a <111> oriented c-Si surface. Moreover passivation may depend of the conductivity type of the substrate.

Experimentally, the overall passivation by a single intrinsic a-Si:H layer of a textured c-Si surface including randomly distributed pyramids has drawbacks as compared to the excellent passivation by an intrinsic a-Si:H layer of a polished c-Si surface : the resulting open circuit voltage (Voc) of a textured silicon heterojunction can be lowered by 100 mV, the fill factor by 10 % and the overall PV cell efficiency can decrease from 17.6% to 14.6% (S. Olibet, C. Monachon, A. Hessler-Wyser, E. Vallat-Sauvain, S. De Wolf, L. Fesquet, J. Damon-Lacoste, and C. Ballif, "Textured silicon heterojunction solar cells of over 700 mV open-circuit voltage studied by transmission electron microscopy," in Proc. of the 23rd EU PV Conference, Valencia, Spain, 2008, p. 1140). Surface passivation of a textured surface of randomly distributed pyramids appears to be very sensitive to growth inhomogeneities in the pyramid bottoms after the growth of μc-Si:H on top of passivation layer consisting of an intrinsic a-Si:H layer. Deposition of intrinsic amorphous silicon on a randomly textured surface can lead to local epitaxial growth which is detrimental to the passivation.

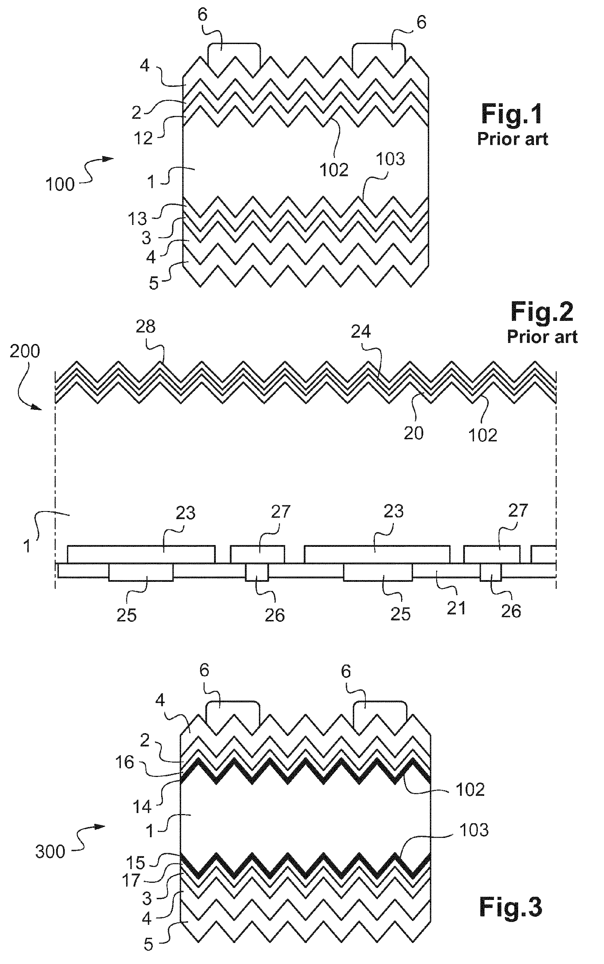

Nevertheless, passivation of randomly textured c-Si has been successfully implemented in the PV industry. Recently, an industrial heterojunction device providing a record 24.7 % efficiency has been presented (Taguchi et al. 24.7% Record Efficiency HIT Solar Cell on Thin Silicon Wafer, IEEE Journal of Photovoltaics, vol. 4, no. 1, pp. 96-99, Jan. 2014). Figure 1 shows the structure of such a heterojunction with intrinsic thin-layer (HIT) structure. The HIT device 100 comprises a randomly textured n-type Czochralski (CZ) crystalline silicon wafer 1, with a randomly textured front surface 102, an intrinsic (i-type) layer 12 of amorphous hydrogenated silicon ((i) a-Si:H) of approximately 5 nm thickness deposited on the textured front surface 102 and a p-type a-Si:H layer 2 deposited onto the intrinsic a-Si:H layer to form a p/n heterojunction on the front side of the HIT solar cell. The heterojunction comprises another intrinsic (i-type) layer 13 of amorphous hydrogenated silicon (a-Si:H) of approximately 5 nm thickness deposited on the opposite textured back surface 103 and an n-type a-Si:H layer 3 deposited onto the intrinsic a-Si:H layer 13 to form a back surface field structure (BSF). Transparent conductive oxide layers 4 are deposited on both sides of the heterojunction device 100. The front electrodes 6 are deposited along a grid which design is optimized to reduce shadowing effects. A rear electrode 5 is deposited on the backside of the heterojunction device 100. In this device, the intrinsic a-Si:H layers 12, 13 provide effective passivation on both randomly textured surfaces of the n-type c-Si substrate. This HIT device provides a high open-circuit voltage (Voc) of 750 milliVolt, a high conversion efficiency of 24.7 % and an excellent temperature coefficient.

Thus, the heterojunction with intrinsic thin-layer (HIT) structure comprising an intrinsic amorphous silicon (i a-Si:H) passivation layer is broadly recognized in the photovoltaic community as one of the most promising structure that enables both high efficiency and low cost. Such results are obtained by optimizing the wafer preparation before the a-Si:H deposition and modifying the deposition process of the a-Si layers. Taguchi et al. identify three key issues to achieve the highest conversion efficiency: wafer quality, wafer preparation and a-Si:H quality.

Very high efficiencies of 25.6% have also been reported for IBC HiTs structures which also include the passivation of textured c-Si by a thin layer of (i) a-Si :H but in IBC architecture (close to homojunctions but with n and p a-Si :H regions deposited in the back instead of diffused).

Other solar cells structures have been developed but they do not reach such high results in terms of open-circuit voltage (Voc) and conversion efficiency.

For example heterojunction solar cells comprising a p-type silicon substrate and an emitter system consisting of a n-doped hydrogenated, amorphous silicon-carbide a-SiC:H(n), with or without an intermediate pure, hydrogenated, intrinsic amorphous silicon layer a-Si:H (i) have been realized both on flat silicon surface and on textured inverted pyramids surface (D. Pysch, M. Bivour, M. Hermle, and S. W. Glunz, "Amorphous silicon carbide heterojunction solar cells on p-type substrates," Thin Solid Films, vol. 519, no. 8, pp. 2550-2554, Feb. 2011). The optimum solar cell efficiency of 18.5 % was realized with a single-layer of a-SiC:H (n) emitter with a thickness of 11 nm on an inverted pyramid textured surface. However, the highest open circuit voltage of 690 mV is obtained on a flat surface with an interface (i) a-Si:H layer. More precisely, a deviation of the Voc behavior on flat versus textured surface is observed. Generally, the Voc does not increase when inserting an (i) a-Si:H layer on inverted pyramids silicon surface. This deviation is attributed to the different crystallographic orientations at the interface, especially at the pyramid valleys and edges, which can decrease the passivation quality due to the different growth mechanisms of amorphous silicon at the different crystal orientations. To overcome that problem, Pysch et al. suggest smoothing the edges and tips of the pyramids in a chemical polishing solution before the amorphous silicon is deposited.

Figure 2 represents another prior art back-contacted homojunction solar cell device 200. Compared to a conventional SHJ solar cell as disclosed in Figure 1, the device 200 of figure 2 comprises only backside electrodes 25 and 26. This structure enables to suppress shadowing effects due to the front side electrodes in conventional solar cells. The homojunction device 200 comprises a n-type c-Si wafer substrate 1, a front-side field structure (FSF) and a backside field structure (BSF). The substrate 1 has a textured front surface 102 and a flat back surface. The front-surface field structure usually comprises a thin a-SiNx:H layer 26 and a silicon dioxide layer 24, to suppress front carrier recoupling. An anti-reflection film 28 enables to reduce front surface reflectivity. The textured front surface 102 also reduces front surface reflectivity and further increases coupling of incoming photons into the homojunction device. The BSF comprises localized contacts of opposed conductivity types: contacts 23 correspond to p+ doped regions and contacts 27 correspond to n+ doped regions. A silicon dioxide layer 21 usually provides back surface passivation. This SiO$_2$ layer 21 enables to reduce surface recombination losses at the back-surface and to increase back surface reflectivity. Positive electrodes 25 are connected to the contacts 23 and, respectively, negative electrodes 26 are connected to the contacts 27. Industrial solar cells based on such back-contacted homojunction devices 200 can provide conversion efficiencies up to 25%.

Nevertheless, at present, improvement of solar cell efficiency providing both a higher conversion efficiency and open circuit voltage while keeping the costs low, remains an issue. More specifically, the passivation of textured surfaces in homojunction and heterojunction solar cells at low temperature (below 250°C) remains difficult, thus requiring quality wafer preparation and the use of other materials, such as a-Si:H.

**Technical Problem**

One goal of the invention is to propose a solar cell comprising a randomly textured crystalline semiconductor substrate, and at least one layer of intrinsic hydrogenated amorphous silicon for passivating said randomly textured surface, without inducing local epitaxial growth of said (i) a-Si:H layer.

Another goal of the invention is to propose an alternative method for passivating a textured semiconductor substrate, said method for passivating being tolerant to the randomly textured surface imperfections.

Another goal of the invention is to propose a method for passivating a randomly textured semiconductor substrate in a solar cell of heterojunction or homojunction type, including front contact and IBC architectures.

Still another goal of the invention is to provide a method of manufacturing a solar cell or an optoelectronic device.

**Summary of the invention**

The present invention thus provides a solar cell comprising a substrate comprising a crystalline semiconductor material, having at least one randomly textured surface, and a layer of intrinsic hydrogenated amorphous silicon for passivating said randomly textured surface, and a layer of intrinsic hydrogenated amorphous carbide-silicon alloy on said textured surface between said randomly textured surface and said layer of intrinsic hydrogenated amorphous silicon.

In the present document, the term "a layer on a surface" means that this layer is directly in contact with this surface. This structure may result from a various deposition or growth processes. Similarly, "a layer on another layer" means that these two layers are in contact with each other, regardless of the deposition or growth order of these two layers.

The particular solar cell structure presenting a combination of a layer of intrinsic hydrogenated amorphous carbide-silicon alloy (a-SiC$_x$:H) and a layer of intrinsic hydrogenated amorphous silicon (i a-Si:H) provides an excellent passivation of the randomly textured surface even when imperfections are present on the textured surface. The layer of intrinsic hydrogenated amorphous carbide-silicon alloy (a-SiC$_x$:H) impedes local epitaxy of the intrinsic hydrogenated amorphous silicon (i a-Si:H) layer. The implementation of these (i) a-Si:H and (i)a-SiC:H passivating layers enables to increase both the open circuit voltage and the overall conversion efficiency of the solar call, as compared to a conventional solar call formed on the same textured surface and comprising a single passivating layer of purely intrinsic amorphous hydrogenated silicon (i a-Si:H).

Moreover, surprisingly, these layers provide an increase in the fill factor of the solar cell.

According to a particular aspect of the invention, said substrate comprises two opposed randomly textured surfaces, two layers of intrinsic hydrogenated amorphous silicon, each of said two layers of intrinsic hydrogenated amorphous silicon passivating each of said two opposed randomly textured surfaces, and two layers of intrinsic hydrogenated amorphous carbide-silicon alloy, each of said two layers of intrinsic hydrogenated amorphous carbide-silicon alloy being respectively on each of said two opposed randomly textured surfaces, and wherein each of said two layers of intrinsic hydrogenated amorphous carbide-silicon alloy is respectively between each of said two randomly textured surfaces and each of said two layers of intrinsic hydrogenated amorphous silicon.

According to a particular aspect of the invention, said layer of intrinsic hydrogenated amorphous carbide-silicon alloy has a thickness comprised between one monolayer and 20 nm, and preferably below 5 nm over said textured surface.

Advantageously, said thin layer of intrinsic hydrogenated amorphous silicon has a thickness comprised between 1 monolayer and 100 nm, and preferably lower than 10 nm.

This layer of intrinsic hydrogenated amorphous silicon further improves the randomly textured surface passivation.

According to a preferred aspect of an embodiment of the invention, said at least one randomly textured surface comprises microstructures shaped in pyramids and/or inverted pyramids.

Preferably, in the latter case, said microstructures shaped in pyramids and/or inverted pyramids comprise facets of substantially <111> crystallographic orientation.

According to a particular and advantageous embodiment, said substrate comprises monocrystalline silicon or polycrystalline silicon.

According to a particular said solar cell further comprises at least an additional layer on said layer of intrinsic hydrogenated amorphous silicon for further passivating said at least one randomly textured surface.

According to an embodiment of the invention, said additional layer comprises a layer of doped amorphous hydrogenated silicon (a-Si:H), or doped amorphous hydrogenated silicon-carbide (a-SiC:H), or doped amorphous hydrogenated silicon-oxide (a-SiO:H), or doped microcrystalline hydrogenated silicon ($\mu$c-Si:H), or doped microcrystalline hydrogenated silicon-carbide ($\mu$c-SiC:H) or doped microcrystalline hydrogenated silicon-oxide ($\mu$c-SiO:H).

According to an advantageous embodiment of the invention, said substrate consists in a silicon wafer comprising two opposed textured surfaces, and each of said two opposed textured surfaces comprises a stack of layers consisting in a thin intrinsic hydrogenated amorphous layer of a silicon-carbide alloy deposited on each of said silicon wafer textured surface and a thin intrinsic hydrogenated amorphous silicon layer deposited on said thin intrinsic hydrogenated amorphous layer of a silicon-carbide alloy.

According to a particular aspect, the solar cell further comprises a transparent conductive oxide layer and at least one front contact on a front side of the device.

According to another particular aspect, the solar cell further comprises interdigitated back contacts.

The invention also provides a method of manufacturing a solar cell comprising the steps of:

> a. Providing a substrate of a crystalline semiconductor material, said substrate having at least one randomly textured surface;
> b. Depositing a intrinsic hydrogenated amorphous layer of a carbide-silicon alloy on said at least one randomly textured surface; and
> c. Depositing a layer of intrinsic hydrogenated amorphous silicon on said layer of intrinsic hydrogenated amorphous carbide-silicon alloy.

This method applies in particular to the manufacturing of silicon homojunctions and heterojunctions (SHJ), either with front contacts or Interdigitated Back Contact.

According to a particular aspect, the method of manufacturing a solar cell further comprises an additional step d) after said step c) of :

> d. Depositing at least an additional layer on said layer of intrinsic hydrogenated amorphous silicon.

According to a particular aspect, the step a) comprises providing a substrate of crystalline silicon and a step of texturing said substrate, so as to produce said at least one randomly textured surface.

The method of the invention enables to grow 100 % amorphous silicon a-Si:H on a textured crystalline silicon substrate at low temperature (<200°C). The carbide-semiconductor alloy prevents epitaxial growth of silicon on the randomly textured surface.

According to a particular and advantageous aspect of the invention, said step of texturing a substrate of crystalline silicon comprises a step of anisotropic chemically wet-etching.

As an example, anisotropic wet-etching can be performed, but not limited to, in a solution of sodium hydroxide or potassium hydroxide or any other alkaline metal hydroxides or solutions such as TMAH or TEOH, with or without isopropyl alcohol, so as to produce at least one randomly textured surface comprising microstructures shaped in pyramids and/or inverted pyramids, said textured surface comprising facets of substantially <111> crystallographic orientation.

According to another particular and advantageous aspect of the invention, the step b), c) and/or d) comprise a step of chemical vapor deposition at a temperature below 400°C.

According to a particular and advantageous aspect of the invention, the step b) comprises a step of plasma enhanced chemical vapor deposition or hot wire chemical vapor deposition using a gas mixture of silicon-rich gas ($SiH_4$, $Si_2H_6$, $SiF_4$, $SiCl_3H$, $SiCl_2H_2$, etc.) and a carbon-rich gas, such as methane, with or without dihydrogen.

The invention applies in particular to high efficiency heterojunction solar cells and optoelectronic devices.

The present invention also concerns the features disclosed in the following description and which are to be considered isolately or according to any feasible technical combination.

## Brief description of the drawings

This description is given for non limiting illustrative purposes only and will be better understood when referring to the annexed drawings wherein:

- Figure 1 represents schematically a cross-section of an heterojunction with intrinsic thin-layer (HIT) solar cell of the prior art;
- Figure 2 represents schematically a cross-section of an homojunction-type solar cell in an IBC configuration, of the prior art;
- Figure 3 represents schematically a cross-section of a heterojunction solar cell according to a first embodiment of the invention;
- Figure 4 represents schematically a cross-section of a heterojunction solar cell according to a test structure;
- Figure 5 represents the current-voltage J(V) characteristics for a test device according to Figure 4 (square-mark) and for a device according to Figure 3 (disk-mark), both on potassium hydroxide with isopropyl alcohol (KOH/IPA) textured substrates ;
- Figure 6 represents the current-voltage J(V) characteristics for a test device according to Figure 4 (square-mark) and for a device according to Figure 3 (disk-mark), both on IPA-free potassium hydroxide (KOH/surfactant) textured substrates;
- Figure 7 represents schematically a cross-section of an IBC type homojunction solar cell according to another embodiment of the invention;
- Figure 8 represents schematically steps of a method for manufacturing a solar cell according to the invention;
- Figure 9 represents schematically a cross-section of a homojunction solar cell with front contacts according to another embodiment of the invention.

## Detailed description

Device

Figure 3 schematically represents the structure of a heterojunction device 300 according to a first embodiment of the invention.

The same reference numbers as used in relation with Figure 1, refer to the same elements.

The device 300 comprises a crystalline semiconductor substrate 1. Preferably, the substrate comprises a crystalline silicon substrate 1. The substrate 1 may be a Czochralski (CZ) or Floating Zone (FZ) monocrystalline silicon (c-Si) substrate. The substrate 1 may have a conductivity type resulting from n-doping (for example phosphorus doped) or from p-doping (for example boron doped).

The substrate 1 has a thickness comprised between 1 and 700 micrometers.

In the following example, the substrate 1 consists in an n-doped monocrystalline silicon wafer having a thickness of about 230 microns.

The substrate 1 has a frontside textured surface 102 and a backside textured surface 103. These textured surfaces 102, 103 can result from anisotropic chemical wet-etching. In a preferred embodiment, the textured surfaces 102, 103 comprise randomly distributed pyramids, the facets of these pyramids being mostly of <111> crystallographic orientation. Generally, the base dimension of these pyramids is comprised between 1 and 20 microns. According to the texturing and cleaning processes, however, some imperfections may be present at the bottoms and/or at the edges of the pyramids.

In the example of Figure 3, the front side passivation interface comprises a stack of interface layers 14, 16. More precisely, this stack of interface layers consists of a thin intrinsic amorphous hydrogenated silicon-carbide (a-SiC:H (i)) layer 14 and a thin intrinsic amorphous hydrogenated silicon (a-Si:H (i)) layer 16, the a-SiC:H (i) layer 14 being inserted between the textured c-Si surface 102 and the intrinsic a-Si:H (i) layer 16.

The a-SiC:H (i) layer 14 has a thickness generally comprised between one monolayer and 5 nm. Preferably, the a-SiC:H (i) layer 14 has a thickness comprised between 1.5 nm and 2.5 nm.

The a-Si:H (i) layer 16 has a thickness generally comprised between 2.5 and 10 nm.

As an example, the a-SiC:H (i) layer 14 has a thickness of 2.5 nm and the a-Si:H (i) layer 16 has a thickness of 2.5 nm.

These interface layers 14 and 16 replace the conventional single intrinsic amorphous hydrogenated silicon layer 12 of the HiT device 100 of Figure 1. Instead of depositing the pure silicon intrinsic amorphous hydrogenated silicon (a-Si:H (i)) layer on the randomly textured silicon surface as in the prior art solar cell of Fig. 1, a layer 14 of intrinsic amorphous hydrogenated silicon-carbide (a-SiC:H (i)) is deposited on the randomly textured surface 102 in the solar cell according to the first embodiment illustrated on Figure 3. Thus, the intrinsic amorphous hydrogenated silicon (a-Si:H (i)) layer 16 is not on the randomly textured silicon substrate surface 102 but on the intrinsic amorphous hydrogenated silicon-carbide (a-SiC:H (i)) layer 14.

An additional layer 2 of semiconductor material is deposited on the stack of interface passivating layers 14, 16. More precisely, the layer 2 is deposited on the intrinsic amorphous hydrogenated silicon layer 16. Preferably, the layer 2 is made of doped silicon. This layer 2 can be amorphous or microcrystalline and can contain impurities to tune its properties (carbon, oxygen,...). This layer 2 of semiconductor material has a second conductivity type which is different from the first conductivity type of the substrate 1.

As an example, the substrate is an n-type c-Si wafer, and the emitter layer 2 on the front side is a p-doped amorphous hydrogenated silicon ((p) a-Si:H) or a p-doped amorphous hydrogenated silicon-carbide ((p) a-SiC:H), or p-doped amorphous hydrogenated silicon-oxide ((p) a-SiO:H), or a p-doped micro-crystalline hydrogenated silicon ((p) $\mu$c-Si:H) or a p-doped micro-crystalline hydrogenated silicon oxide ((p)$\mu$c-SiO$_x$:H), or p-doped microcrystalline hydrogenated silicon-carbide ((p) $\mu$c-SiC:H). The front side field structure of the device 300 thus forms a p-n heterojunction.

Alternatively, the substrate is a p-type c-Si wafer, and the emitter layer 2 is n-doped of hydrogenated silicon of either kind as in the preceding paragraph.

Similarly, on the backside, a passivation interface comprises a stack of interface layers 15, 17. More precisely, this stack of interface layers consists of a thin intrinsic amorphous hydrogenated silicon-carbide (a-SiC:H (i)) layer 15 and a thin intrinsic amorphous hydrogenated silicon (a-Si:H (i)) layer 17, the a-SiC:H (i) layer 15 being inserted between the textured c-Si surface 103 and the intrinsic a-Si:H (i) layer 17. Thus, the layer 15 of intrinsic amorphous hydrogenated silicon-carbide (a-SiC:H (i)) is deposited on the randomly textured surface 103 in the solar cell according to the first embodiment illustrated on Figure 3.

These interface layers 15 and 17 replace the conventional single intrinsic amorphous hydrogenated silicon layer 13 of the HIT device 100 of Figure 1. The intrinsic amorphous hydrogenated silicon (a-Si:H (i)) layer 17 is not on the randomly textured silicon substrate surface 102 but on the intrinsic amorphous hydrogenated silicon-carbide (a-SiC:H (i)) layer 15.

On the backside of the device 300, another layer 3 of semiconductor material is deposited on the stack of interface passivating layers 15, 17. Preferably, the layer 3 is made of doped silicon. This layer 3 can be amorphous or microcrystalline and can contain impurities to tune its properties (carbon, oxygen,...). More precisely, this layer 3 is deposited on the intrinsic amorphous hydrogenated silicon layer 17. This layer 3 of semiconductor material has the same conductivity type as the first conductivity type of the substrate 1. For example, the substrate 1 is an n-type c-Si wafer and the backside field structure comprises a layer 3 of n-doped amorphous hydrogenated silicon ((n) a-Si:H) or n doped micro-crystalline hydrogenated silicon ((n) μc-Si:H) or n doped micro-crystalline hydrogenated silicon oxide ((n) μc-SiOx:H).

Then, a transparent conductive oxide (TCO) layer 4, 5 is deposited on both sides of the device 300. For example, the TCO layer 4, 5 comprises an indium-tin oxide (ITO) layer or an aluminum doped zinc oxide (ZnO:Al) layer deposited by physical vapor deposition (PVD), for example by sputtering. As an alternative, the TCO layers 4, 5 comprise boron doped zinc oxide (ZnO:B) deposited by low pressure chemical vapor deposition (LPCVD). For example, the TCO layer comprises a layer of ITO of 82 nm.

Metal contacts 5, 6 can be evaporated or screen-printed or deposited by any other technique.

The evaluation of the performance of the heterojunction devices 300 derives from different known measurements techniques of minority carrier effective lifetime (or in short effective lifetime), implied open circuit voltage and overall cell conversion efficiency.

The effective lifetime measured is a combination of three contributions respectively from the bulk, front surface and back surface as expressed in the following expression:

$$\frac{1}{\tau_{eff}} = \frac{1}{\tau_{bulk}} + \frac{1}{\tau_{front}} + \frac{1}{\tau_{back}}$$

where $\tau_{eff}$ represents the measured effective lifetime, $\tau_{bulk}$ represents the bulk lifetime, $\tau_{front}$ represents the front surface recombination lifetime and $\tau_{back}$ represents the back surface recombination lifetime. When dealing with high-quality wafers, the bulk lifetime is usually very high, therefore the limitations come from the front and back surfaces. As a result, a better front and/or back surface passivation leads to a higher measured effective lifetime.

To determine the impact of this thin a-SiC:H layer, the effective lifetimes of two samples are measured right before TCO is sputtered.

A first sample, according to the first embodiment of the invention, comprises stacks of (i) a-SiC:H and (i) a-Si:H interface layers both at the front textured surface and at the back texture surface, as illustrated in Figure 3.

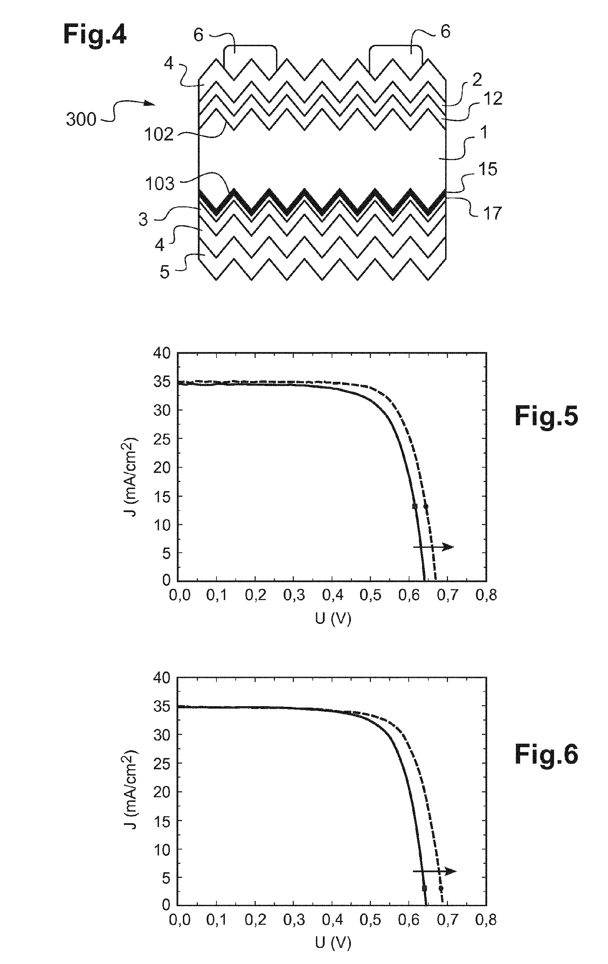

For comparison, a second test sample has been realized with a structure as illustrated on Figure 4. This second sample is a HIT heterojunction device with a single intrinsic a-Si:H layer deposited on the front side and a stack of intrinsic amorphous silicon-carbide and a thin intrinsic hydrogenated amorphous silicon layer on the backside of a similarly textured silicon substrate. This second sample comprises only one intrinsic amorphous hydrogenated silicon-carbide ((i) a-SiC:H) layer 15 at the interface between an intrinsic amorphous hydrogenated silicon ((i) a-Si:H) layer 17 at the textured c-Si back surface 103. This sample comprises a conventional single intrinsic amorphous hydrogenated silicon ((i) a-Si:H) layer 12 at the textured c-Si front surface 102.

Thus, the only difference between these two devices is the thin a-SiC:H layer 15 at the (i) a-Si/c-Si interface on the front side which is present in the device of figure 3 and absent in the test device of Figure 4. The comparison of these two samples enables to evaluate the impact of the a-SiC:H layer on the front-side of the junction.

Measurements of the effective lifetime have been realized, on the one hand, on a test sample comprising a c-Si substrate with randomly textured surfaces on both faces and comprising a single passivating (i) a-Si:H layer on both textured surfaces, and, on the other hand, on another test sample comprising a c-Si substrate with randomly textured surfaces on both faces and comprising symmetrical passivating stacks of (i) a-Si:H layer and (i) a-SiC:H layer on both textured surface. The two substrates are prepared in the same way so that the total thicknesses of the passivating layers are identical, i.e., 28 nm on both sides. It is also assumed that the bulk lifetime contribution is identical for these two measured devices. The difference in effective lifetime measurements can thus be attributed to differences in surface passivation.

These measurements show an increase in effective lifetime from 1940 μs for the test sample with a single (i) a-Si:H layer, up to 3290 μs for the other test sample with the a-SiC:H layer at both a-Si/c-Si interfaces. These effective lifetimes are extracted at a minority carrier density of 2E15 cm$^{-3}$.

Surprisingly, the presence of the thin (i) a-SiC:H layer which introduces impurities at the a-Si/c-Si interface, does not lower the effective lifetime of the heterojunction device 300.

On the contrary, the stacks of interface layers 14-16 and 15-17 are beneficial for the randomly textured c-Si substrate passivation.

Moreover, the implied open circuit voltage (Voc) increases from 716 mV (for a symmetrical test sample with a single a-Si:H layer on both randomly textured surfaces) up to 729 mV when adding the thin a-SiC:H layer at both interfaces of the other test sample.

Thus, surprisingly, applying a stack of layers consisting of an (i) aSiC:H layer and an (i) a-Si:H layer on a textured surface of essentially <111> oriented facets, the a-SiC:H thin layer being deposited on the textured surface, provides excellent passivation properties.

Thus, it derives from the present disclosure that inserting a thin intrinsic amorphous silicon-carbide layer between a randomly textured crystalline silicon surface and an intrinsic amorphous hydrogenated silicon layer provides a better passivation of the randomly textured silicon surface than depositing directly a single intrinsic amorphous hydrogenated silicon layer on a similar randomly textured crystalline silicon surface. Local epitaxy appears to be more limiting than the presence of a wide-bandgap material at the interface, therefore, counterintuitively charge transport is enhanced thanks to the carbide layer.

Indeed, this passivation effect on a textured silicon surface is even more surprising when considering that the application of a single 20 nm thick a-SiC:H layer on flat c-Si surface passivates the substrate to a level of 0.8 ms effective lifetime with an open circuit voltage of 682 mV, which is much worse than a single layer of (i)a-Si:H. Also surprising, a single a-SiC:H layer passivates equally to a level of 0.8 ms effective lifetime a c-Si flat substrate of either <100> or <111> crystallographic orientation.

Thus, the combination of an intrinsic amorphous hydrogenated silicon-carbide layer with an intrinsic amorphous hydrogenated silicon layer and the position of each of these layers with respect to the randomly textured surface provides a better passivation effect than a single (i) a-Si:H layer or a single a-SiC:H layer.

Moreover, the use of an a-SiC:H/a-Si:H stack on a flat <111> c-Si surface does not lead to any difference when compared, respectively, with a sample passivated with a single intrinsic amorphous hydrogenated silicon layer only. Indeed, the effective lifetime is almost identical (respectively 4.8 ms versus 4.9 ms) and the implied Voc values also (respectively 730 mV versus 727 mV).

Contrariwise, the use of an a-SiC:H/a-Si:H stack on a flat <100> c-Si surface leads a major improvement. Indeed, the effective lifetime increases from 30 μs up to 2.6 ms and the implied Voc from 568 mV up to 723 mV when using a thin carbide layer at the interface.

Thus, it derives from the present disclosure that a stack of layers comprising an intrinsic amorphous hydrogenated silicon-carbide layer on a randomly textured crystalline silicon surface and an intrinsic amorphous hydrogenated silicon layer capping this intrinsic amorphous hydrogenated silicon-carbide layer provides a better randomly textured surface passivation than a single intrinsic amorphous hydrogenated silicon layer or than a single intrinsic amorphous hydrogenated silicon-carbide layer on a similar randomly textured crystalline silicon surface.

These passivation properties are attributed at least in part to the a-SiC:H layer that may prevent local crystallographic growth on a randomly textured surface comprising planes of different crystallographic orientations. In the case of a passivating interface comprising an (i) a-SiC:H layer and an (i) a-Si:H layer, the passivation effect may also be attributed for another part to the (i) a-Si:H layer which further improves the surface passivation effect of the (i) a-SiC:H covered textured surface.

An improvement in the level of passivation is observed when the front side is covered by the thin a-SiC:H layer 14 at the interface between the randomly textured c-Si surface and the intrinsic amorphous silicon layer 16 in the heterojunction solar cell of Figure 3, as compared to the test heterojunction solar cell of Figure 4 with only a single a-Si:H layer on both textured surfaces 102, 103. Thus, the heterojunction solar cell of Figure 4 appears to be limited by the side without a thin a-SiC :H layer in the front. This witness heterojunction solar cell of Figure 4, has the same passivation level as a sample with no a-SiC :H layer on either side.

Similar results are obtained when depositing only a single a-Si:H passivating layer 13 on the back textured surface 103 and depositing a stack consisting of a thin a-SiC:H layer 14 and an a-Si:H layer 16 on the front textured surface 102.

However, the best results are obtained when depositing a thin a-SiC:H layer on both textured surfaces 102, 103 rather than only on either one of the textured surfaces 102, 103.

Thus, it appears that the effective lifetime is limited by the front- or back- side which does not include an a-SiC:H layer on the textured silicon surface.

Different texturing techniques have been experimented.

In a first example, the textured silicon substrate is obtained using a 1.7%-dilute potassium hydroxide at 80°C (in water) with isopropyl alcohol (IPA) as an additive to improve the wettability of the silicon surface.

More specifically, the heterojunction structure corresponding to that of Fig. 3 comprising an a-SiC:H layer 14 inserted between a KOH/IPA textured c-Si surface 102 and the intrinsic amorphous silicon layer 16 yields an effective lifetime of 0.8 ms and an implied open circuit voltage Voc of 698 mV. For comparison, an heterojunction structure corresponding to that of Fig. 4 yields a minority carrier effective lifetime of 0.4 ms with an implied open circuit voltage Voc of 676 mV.

Another comparison is illustrated on Figure 5 which represents the current-voltage J(V) characteristics for the witness HiT cell (square-mark on straight line, corresponding to a structure as represented on figure 4) and respectively for the heterojunction device according to the first embodiment of the invention (disk-mark on dashed-line, corresponding to a structure as represented on figure 3) with a thin a-SiC:H layer at the interface. The test HiT structure based on a KOH/IPA textured substrate with a single a-Si:H layer passivation layer at the front textured surface 102 and a thin a-SiC:H layer on the back textured surface 103 only exhibits an open circuit voltage Voc of 643 mV. The heterojunction device according to Figure 3, with a thin a-SiC:H layer on both textured surfaces 102, 103 and an a-Si:H layer on each a-SiC:H layer, shows an open circuit voltage Voc of 668 mV. The increase in the heterojunction cell open circuit voltage from 643 mV for a test HIT structure to 668 mV for the heterojunction according to Figure 3, is a clear indication for an improved passivation quality of the randomly textured silicon surface 102. The heterojunction cell architecture of Figure 3 shows a higher conversion efficiency of 18.6% as compared to the 15.9% conversion efficiency for the test HIT structure based on a KOH/IPA textured substrate, as represented on Figure 4. This higher conversion efficiency is mainly due to the higher Voc of 668 mV for the heterojunction cell according to the first embodiment, using a KOH/IPA texturing method, as compared to the test HiT structure represented in Figure 4.

In a second example, the textured silicon substrate is obtained using a completely different texturing recipe: 1.7%-dilute potassium hydroxide (KOH) solution (in water) kept at temperature of 80°C with surfactant where an industrial additive (RENA monotex) replaces the classical IPA additive.

Minority carrier effective lifetime is measured for an HiT structure with only one a-SiC:H layer 15 at the interface between an a-Si:H layer 17 and the KOH/RenaTex textured c-Si surface 103 (as shown in Fig. 4). Minority carrier effective lifetime is also measured for an HiT structure with an a-SiC:H layer 14, 15 at both a-Si/c-Si interfaces (frontside and backside, as shown in Fig. 3). As a result, the effective minority carrier lifetime increases from 0.5 ms for a KOH/RenaTex heterojunction device as of Fig. 4 up to 1.8 ms for a KOH/RenaTex heterojunction device as of Fig. 3. At the same time, the implied open circuit voltage Voc increases from exhibits 681 mV for a KOH/RenaTex heterojunction device as of Fig. 4, up to 716 mV for a KOH/RenaTex heterojunction device as of Fig. 3. This corresponds to a gain in open circuit voltage Voc of +35 mV.

Figure 6 illustrates the current-voltage J(V) characteristics for this test HiT cell resulting from KOH/RenaTex surface texturing (square-mark straight line, corresponding to a finished solar cell based on a structure as represented on figure 4) and respectively for the heterojunction device according to the first embodiment of the invention (disk-mark dashed line, corresponding to a finished solar cell based on a structure as represented on figure 3) with KOH/RenaTex surface texturing and a thin a-SiC:H layer at the interface. The conversion efficiency of both KOH/RenaTex heterojunction structures is also measured. Heterojunction cell architecture as presented in figure 3 shows a higher conversion efficiency of 17.5% as compared to 16.4% conversion efficiency for an HIT structure based on a KOH/RenaTex textured substrate, as represented on Figure 4. This higher conversion efficiency is mainly due to the higher open circuit voltage Voc of 684 mV for the heterojunction cell according to the first embodiment, using a KOH/RenaTex texturing method, as compared to an open circuit voltage Voc of 643 mV for the test KOH/RenaTex textured HIT structure of Figure 4 (see figure 6).

Thus, for KOH/RenaTex textured substrates too, the thin a-SiC:H layer 14 is beneficial. Introducing an a-SiC :H thin layer at the interface on one side only (front or rear side) will suppress all local epitaxial growth on the chosen side and this will improve the passivation. However, this is not detectable by PCD since we are always limited by side where local epitaxial growth is not impeded. The J(V) characteristics will however be improved compared to a standard HiT architecture, especially if the carbide layer is situated at the interface of the pn junction where recombination are more critical. Introducing a thin a-SiC :H layer at both interfaces suppresses epitaxial growth on both sides and leads to even a high passivation level (detectable by PCD).

This demonstrates that the insertion of an (i) a-SiC:H layer 14 combined with an (i) a-Si:H layer 16 on randomly textured c-Si wafer surface 102 and/or an (i) a-SiC:H layer 15 combined with an (i) a-Si:H layer 17 on another randomly textured c-Si wafer surface 103, improves the minority carrier effective lifetime. An increase of the open circuit voltage Voc is observed which results in higher conversion efficiency. More precisely, an overall improvement of the conversion efficiency by more than 1 point for two very different texturing recipes, respectively KOH/IPA and KOH/RenaTex, is obtained. A champion cell with a conversion efficiency of 20.1% has been obtained on a 2x2 $cm^2$ solar cell by using a KOH/RenaTex textured wafer according to this first embodiment of the invention.

Additionally, dark current measurements are obtained, on the one hand, for a HiT cell as illustrated on figure 4 and, on the other hand, for an heterojunction device according to the first embodiment, containing a stack of thin a-SiC:H layer and (i) a-Si:H layer on both randomly textured sides, as illustrated on Figure 3. The heterojunction device according to the first embodiment (including a stack of thin a-SiC :H layer and (i) a-Si:H layer at the textured interface) present a lower dark current on the whole bias range as compared to the HiT structure of Figure 4. This result indicates that the presence of carbon at the interface is not detrimental for the transport in the dark and that on the contrary, by suppressing local epitaxial growth, it is improved. In fact, the solar cell structure according to the invention presents less leakage current than the convention HiT solar cell thus confirming the beneficial effects of the a-SiC :H layer at the a-Si/c-Si interface.

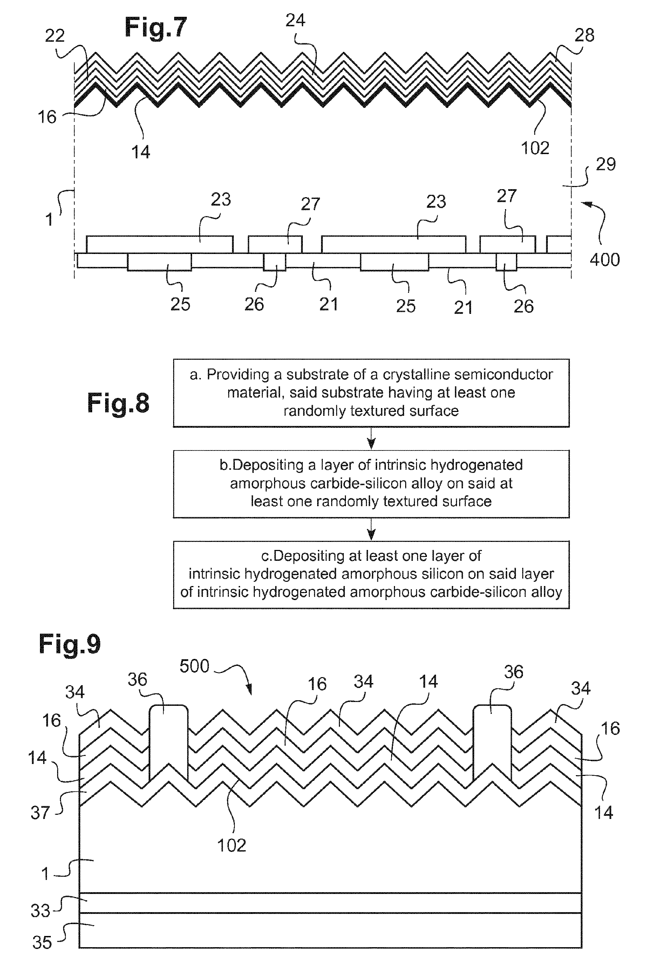

Figure 7 represents schematically a cross-section of an IBC homojunction solar cell 400 according to another embodiment of the invention.

The same reference signs as used in Figure 2 refer to the same elements : a crystalline silicon substrate 1 with only a front textured surface 102. The substrate comprises for example a region 29 which is n-doped, some regions 23 on the backside which are p+ doped and other regions on the backside which are n+ doped, thus forming a homojunction device. A layer 22 of n-doped amorphous silicon is deposited on the front side. A layer of silicon dioxide 24 is deposited on the n-doped a-Si:H layer. An anti-reflection coating 28 is deposited on top of the front side homojunction device 400.

As compared to Figure 2, the device 400 of figure 7 comprises at least one thin layer of intrinsic amorphous hydrogenated silicon-carbide 14 . More precisely, this intrinsic amorphous hydrogenated silicon-carbide (a-SiC:H (i)) layer 14 is inserted between the textured c-Si front surface 102 and an intrinsic a-Si:H layer 16.

The stack consisting of the a-SiC:H (i) layer 14 and the a-Si:H (i) layer 16 provides excellent surface passivation of the textured surface homojunction device 400. Although a single layer of a-SiC:H (i) layer 14 provides poor passivation properties.

In a preferred embodiment illustrated on figure 7, a stack of layers consists of a thin intrinsic amorphous hydrogenated silicon-carbide (a-SiC:H (i)) layer 14 on the randomly textured surface 102 and a thin intrinsic amorphous hydrogenated silicon (a-Si:H (i)) layer 16 on the a-SiC:H (i)) layer 14. More precisely, the a-SiC:H (i) layer 14 is inserted between the randomly textured c-Si surface 102 and the intrinsic a-Si:H (i) layer 16.

This stack of layers 14 and 16 is inserted between the textured crystalline surface 102 and the amorphous layer 22 of n-doped a-Si:H which provides the front surface field structure.

This interface stack provides effective passivation of the randomly textured surface. The a-SiC:H (i) layer 14 contains carbon which is not a dopant, but an impurity and which prevents epitaxial growth of the a-Si:H (i) layer 16 on the textured crystalline silicon surface 102. The carbon content of the a-SiC:H (i) layer 14 is comprised between 0.01 % and 80 %, and preferably between 20% and 30%.

The passivation technique can be applied to industrially-textured wafers which are used for industrial production of solar cells with only backside electrodes. Indeed, the effective lifetime almost doubles and the implied open circuit voltage (iVoc) increases by +8mV as compared to a conventional solar cell as illustrated in figure 2. These preliminary results could turn into huge improvements in passivation if adequately implemented to production lines.

In a variant, the backside field structure comprises a stack of layers consisting of a thin intrinsic amorphous hydrogenated silicon-carbide (a-SiC:H (i)) layer 15 and a thin intrinsic amorphous hydrogenated silicon (a-Si:H (i)) layer 17 deposited on the bare back c-Si flat surface and a thick silicon dioxide layer 21 used to increase back surface reflectivity. This stack of a-SiC:H (i) and a-Si:H (i) layers may replace the silicon dioxide passivation layer 21.

Another advantage of passivation using a stack of a-SiC:H (i) and a-Si:H (i) layers is the lower manufacturing cost as compared to deposition of a silicon dioxide layer, due to the lower deposition temperatures (less than 250°C for a-SiC:H and a-Si:H, instead of more than 1000°C for silicon dioxide).

The doped regions 23 and 27 are generally diffused in IBC homojunction device.

Alternatively, the doped regions 23 and 27 can be deposited locally by PECVD on top of passivating intrinsic a-Si:H layers under the form of doped hydrogenated amorphous or microcrystalline silicon to form an Interdigitated back contact heterojunction with intrinsic thin-layer IBC-HiT device.

Other IBC structures may include a textured back surface 103, and benefit similarly from passivating this textured surface 103 using a stack of (i) a-SiC:H layer 15 and (i) a-Si:H layer 17 as described above.

Figure 9 represents schematically in cross-section a front contact homojunction device 500 according to another embodiment of the invention. The homojunction device 500 comprises a p-type c-Si substrate 1 having a randomly textured surface 102 on the front side with an n+ emitter region 37 in the front, a p+ back surface field region 33 and a backside electrode 35, formed for example of screen-printed aluminum paste. The n+ emitter region 37 and the p+ back surface field region 33 may be formed by diffusion of dopants respectively on each side of the c-Si substrate 1. The front metallic contacts 36 are in electrical contact with c-Si substrate. For passivating the front side of the homojunction device 500, a layer 14 of intrinsic hydrogenated amorphous silicon-carbide alloy is placed on the randomly textured surfaces of the c-Si substrate which are not covered by the front contacts 36, and a layer 16 of intrinsic hydrogenated amorphous silicon is placed on the layer 14 of intrinsic hydrogenated amorphous silicon-carbide alloy. An ARC coating 34 is placed on the layer 16 of intrinsic hydrogenated amorphous silicon. The layer 14 of (i) a-SiC:H and the layer 16 of (i) a-Si:H enable to effectively passivate the randomly textured surface of the front side emitter region 37 so as to repel the charge carriers away from the front surface except for the areas of front side emitter region 37 which are directly in contact with the front side contacts 36.

As a complement, an additional layer may be inserted between the layer 16 of intrinsic hydrogenated amorphous silicon and the ARC coating 34. This additional layer may be for example an n+ doped hydrogenated amorphous or microcrystalline silicon or silicon-carbide alloy for further enhancing the field effect passivation on the front side.

Those skilled in the art will recognize that the present invention is not limited to the above described embodiments but also applies to the passivation of other devices comprising the passivation of a randomly textured c-Si surface using hydrogenated amorphous silicon.

In particular, the invention applies to the passivation of polycrystalline silicon substrates having a randomly textured surface in the manufacturing of optoelectronics devices.

## Method

Figure 8 represents schematically steps of a method for manufacturing a heterojunction solar cell according to the invention.

## Step (a)

At the step a), a substrate 1 of a crystalline semiconductor material is provided, said substrate 1 having at least one microstructurally textured surface 102 and/or 103.

Crystalline silicon wafers can be textured using anisotropic wet-etching or dry-etching techniques.

For example, dry-etching techniques comprises plasma or vapor-phase dry-etch and nano-imprint.

In particular, wet-etching techniques can be based on the use of alkaline solutions such as sodium hydroxide (NaOH), potassium hydroxide (KOH) or other solutions such as TMAH (tetramethyl ammonium hydroxide $(CH_3)_4$NOH) or TEOH (tetraethylammonium hydroxide). Wet-etching can be applied with or without isopropyl alcohol (or IPA). IPA is commonly added to the alkaline etchants to improve the uniformity of the random pyramid texture. IPA can be useful for improving its wettability of the silicon substrate because it removes hydrogen bubbles that form and stick the silicon wafer surface. This way, uniform pyramid textures can be obtained. However, other techniques have proven successful without any use of IPA. The method of the invention has given good results with wafers textured with or without IPA.

Wet-etching usually results in a substrate with two opposed textured surfaces 102 and 103.

However, some processes, especially dry-etching, provide a substrate with only one textured surface 102.

In any case, the textured substrate must be cleaned chemically before any deposition to avoid any contaminants, for example by using wet cleaning procedures (using HF/HCl, $H_2SO_4/H_2O_2$ and HF routine). Also, the cleaning enables to get rid of the native oxide which grows naturally for example on crystalline silicon surfaces.

Step (b)

The step (b) comprises depositing a thin intrinsic hydrogenated amorphous layer of a carbide-semiconductor alloy 14 and/or 15 on said the textured surface 102 and/or 103.

For example, in a PECVD process, this can be done by adding a carbon-rich gas to the conventional gas mixture used for a-Si:H deposition. For example, methane $(CH_4)$ is added to a silicon-rich $(SiH_4, Si_2H_6, SiF_4, SiCl_3H, SiCl_2H_2)$ and dihydrogen gas mixture to produce a-SiC$_x$:H.

The ratio x of the carbon to silicon content in the a-SiC$_x$:H layer generally depends on the ratio of flow rates of the carbon-rich gas to the silicon-rich gas in the gas mixture.

In an example, the following PECVD conditions are used for deposition of an a-SiC :H layer on a textured silicon wafer surface :

- Temperature : 100-400°C ;
- Total pressure : 5 mTorr-1 Torr;
- Silicon-rich gas (SiH$_4$ for example) partial pressure: 50-400 mTorr ;

- Methane partial pressure: 50-400 mTorr ;
- Hydrogen partial pressure :0-999 mTorr ;
- Interelectrode distance : 2-40 mm.

The plasma reactor is in this example is MVS cluster tool or homemade reactor. The PECVD process is applied for a duration comprised between 1 to 3600 sec.

For example, the PECVD conditions for depositing an a-SiC:H layer are as follows:

- Temperature : 200°C,
- Inter-electrode distance d=28 mm.
- 50 sccm methane (CH$_4$)
- 25 sccm silane (SiH$_4$)
- Total pressure 40 mTorr
- Power density 15 mW/cm$^2$

The thickness of the a-SiC:H layer is at least one monolayer. In an example, the thickness of the a-SiC:H layer on the textured surface is 2.5 nm. Preferably, the thickness of the a-SiC:H layer on the textured surface is below 5 nm.

The thickness of the a-SiC:H layer can be measured using a spectroscopic ellipsometer, for example, provided the sample is tilted on a special stage or by measuring on a flat witness sample and dividing the obtained value by the geometrical factor 1.73 induced by texturing.

Step (c)

The step (c) comprises depositing a thin intrinsic hydrogenated amorphous silicon layer 16 and/or 17 onto said thin intrinsic hydrogenated amorphous layer of a carbide-semiconductor alloy 14 and/or 15, respectively.

In a PECVD process, this can be done by stopping the flow of the carbon-rich gas, and restoring the conventional gas mixture used for a-Si:H deposition. The sample thus remains in the same PECVD deposition chamber without being exposed to air.

In an example, the following PECVD conditions are used for deposition of an a-SiC :H layer on a textured silicon wafer surface :

- Temperature : 100-400°C ;
- Total pressure : 5 mTorr-1 Torr;
- Silane partial pressure: 50-400 mTorr ;
- Hydrogen partial pressure :0-999 mTorr ;
- Interelectrode distance : 1-50 mm.

The PECVD process is applied for a duration comprised between 1 to 3600 sec.

For example, the PECVD conditions for depositing an a-Si:H layer are as follows:

- Temperature : 200°C,
- Inter-electrode distance d=28 mm.
- 50 sccm silane (SiH$_4$)

- Total pressure 50 mTorr
- Power density 15 mW/cm$^2$

The thickness of the (i) a-Si: layer is comprised between one monolayer and ten nanometers. In an example, the thickness of the a-Si:H layer on the textured surface is 2.5 nm. Preferably, the thickness of the a-SiC:H layer on the textured surface is below 10 nm.

The thickness of the a-Si:H layer can also be measured using a spectroscopic ellipsometer, provided the sample is tilted on a special stage or by measuring on a flat witness sample and dividing the obtained value by the geometrical factor 1.73 induced by texturing.

As an option, the method may further include another step d), after the steps b) and c).

Step (d)

The step (d) comprises depositing at least one layer 2, 3, 22 of doped amorphous or microcrystalline silicon onto said thin layer 16, 17 of intrinsic hydrogenated amorphous silicon.

In a PECVD process, this can be done by adding a dopant gas to the conventional gas mixture used for a-Si:H deposition. For example, diborane gas (B$_2$H$_6$) is added to a silane and dihydrogen gas mixture to produce p-doped a-Si:H. In another example, phosphine gas (PH$_3$) is added to a silane and dihydrogen gas mixture to produce n-doped a-Si:H.

Other deposition techniques such as hot wire chemical vapor deposition may be used (HWCVD), for each or all of the above deposition steps b), c) and/or d).

The implementation of this passivation technique enables to improve high-efficiency crystalline silicon solar cell performance.

The present disclosure demonstrates that introducing a thin (i)a-SiC:H layer at the (i) a-Si:H/c-Si interface in the case of textured c-Si wafers improves the minority carrier effective lifetime without affecting the performance of the final electronic device. In fact, we observe an increase of the Voc resulting in higher conversion efficiency from 643 mV up to 668 mV. Moreover, the dark current is reduced on the whole voltage range. This leads to a general improvement of the conversion efficiency from 17.8% to 18.6%.

This passivation technique has been used on many samples and shows an excellent reproducibility.

Moreover, this technique is easy to implement. In most cases, it is enough to add a few sccm of a carbon-rich gas (such as methane for example) during the first seconds of the (i) a-Si:H deposition to improve the passivation quality and thus the electronic device performance.

This method can also play a role to reduce texturation costs because it allows compensating imperfections that are naturally present after wet-chemical etching of crystalline silicon and which can foster local epitaxial growth. It might be more cost-effective to reduce the level of the texturing quality (by using a lower concentration of the very expensive IPA for example) and later compensate these imperfections during the a-Si:H deposition process by adding a carbon-rich gas to the PECVD gas mix upon the first seconds of the deposition.

The underlying physics of the present disclosure is that of the growth processes of amorphous silicon on textured crystalline silicon. When using a layer of a-Si:H to passivate a textured c-Si surface, epitaxial silicon growth may occur at the a-Si:H/c-Si interface. In a PECVD process, this can be fostered by the plasma conditions, such as temperature, pressure, dihydrogen dilution, interelectrode distance, etc. However, imperfections present on the c-Si surface can also play an important role in local epitaxial growth. Indeed, the texturing process, whether by dry-etching or anisotropic wet-etching, does not practically result in a perfectly defined landscape containing only one crystallographic orientation. In particular, when texturing c-Si by anisotropic wet-etching, {111}-oriented facets of randomly distributed pyramids are exposed. However, the c-Si surface may contain local imperfections. These imperfections may foster local epitaxial growth when exhibiting other crystalline orientations such as (100) planes for example. The density of imperfections is usually very small, when the texturing process is optimized. This low density makes the observation of local imperfections extremely difficult if not impossible using high resolution electronic microscope. The champion solar cells prior to the present disclosure rely on close to perfect textured surfaces of {111}-oriented facets.

However, it derives from the present disclosure that the insertion of a thin amorphous hydrogenated silicon-carbon layer on a textured silicon surface enables to improve the passivation properties in terms of effective lifetime and implied open circuit voltage, as compared to the usual intrinsic pure hydrogenated amorphous silicon passivation layer.

This thin amorphous hydrogenated silicon-carbon layer enables to improve the conversion efficiency of silicon homojunctions and heterojunctions with textured surface. This a-SiC:H layer thus improves passivation of the textured surface while still allowing efficient collection of the charge carriers.

The thin amorphous hydrogenated silicon-carbon layer impedes epitaxial growth at the a-Si:H/c-Si interface.

This in turn demonstrates the presence of undetected disoriented crystallographic imperfections on textured surface believed to be perfectly oriented.

The invention may apply to any type of texturing technique and texturing recipe.

The improvement in passivation properties and overall conversion efficiency are probably more important in case of a textured surface comprising a relatively high density of imperfections. However, the invention also applies to texturing techniques providing excellent texturing surface, by enabling passivation of previously undetected imperfections.

## Claims

1. Solar cell (300, 400, 500) comprising :

   - a substrate (1) comprising a crystalline semiconductor material having at least one randomly textured surface (102, 103), and
   - a layer (16, 17) of intrinsic hydrogenated amorphous silicon for passivating said randomly textured surface (102, 103), and
   - a layer (14, 15) of intrinsic hydrogenated amorphous carbide-silicon alloy on said textured surface (102, 103) between said randomly textured surface and said layer (16, 17) of intrinsic hydrogenated amorphous silicon.

2. Solar cell (300) according to claim 1 wherein said substrate (1) comprises two opposed randomly textured surfaces (102, 103), two layers (16, 17) of intrinsic hydrogenated amorphous silicon, each of said two layers (16, 17) of intrinsic hydrogenated amorphous silicon passivating each of said two opposed randomly textured surfaces (102, 103), and two layers (14, 15) of intrinsic hydrogenated amorphous carbide-silicon alloy, each of said two layers of intrinsic hydrogenated amorphous carbide-silicon alloy being respectively on each of said two opposed randomly textured surfaces (102, 103), wherein each of said two layers (14, 15) of intrinsic hydrogenated amorphous carbide-silicon alloy is respectively between each of said two randomly textured surfaces (102, 103) and each of said two layers (16, 17) of intrinsic hydrogenated amorphous silicon.

3. Solar cell (300, 400) according to claim 1 or claim 2 wherein said layer (14, 15) of intrinsic hydrogenated amorphous carbide-silicon alloy has a thickness comprised between one monolayer and 20 nanometers.

4. Solar cell (300, 400) according to any one of claims 1 to 3, wherein said layer (16, 17) of intrinsic hydrogenated amorphous silicon has a thickness comprised between one monolayer and 100 nanometers.

5. Solar cell (300, 400) according to anyone of claim 1 to 4 wherein said at least one randomly textured surface (102, 103) comprises microstructures shaped in pyramids and/or inverted pyramids.

6. Solar cell (300, 400) according to any one of claims 1 to 5 wherein the substrate (1) comprises monocrystalline silicon or polycrystalline silicon.

7. Solar cell (300, 400) according to any one of claims 1 to 6, said solar cell further comprising at least an additional layer (2, 3, 22) on said layer (16, 17) of intrinsic hydrogenated amorphous silicon for further passivating said at least one randomly textured surface (102, 103).

8. Solar cell (300, 400) according to claim 7 wherein said additional layer (2, 3, 22) comprises a layer of doped amorphous hydrogenated silicon, doped amorphous hydrogenated silicon-carbide, doped amorphous hydrogenated silicon-oxide, doped microcrystalline silicon, doped microcrystalline hydrogenated silicon-carbide or doped microcrystalline hydrogenated silicon-oxide.

9. Solar cell (300) according to any one of claims 1 to 8 further comprising at least one front contact (6, 36) on a front side of the device and at least a rear electrode (5, 35).

10. Solar cell (300) according to any one of claims 1 to 8 further comprising interdigitated back contacts (25, 26).

11. Method of manufacturing a solar cell comprising the steps of :

    a. Providing a substrate (1) of a crystalline semiconductor material, said substrate (1) having at least one randomly textured surface (102, 103);
    b. Depositing a layer (14, 15) of intrinsic hydrogenated amorphous carbide-silicon alloy on said at least one randomly textured surface (102, 103) ; and
    c. Depositing a layer (16,17) of intrinsic hydrogenated amorphous silicon on said layer (14, 15) of intrinsic hydrogenated amorphous carbide-silicon alloy.

12. Method of manufacturing a solar cell according to claim 11 further comprising an additional step d) after said step c) of :

    d. Depositing at least an additional layer (2, 3, 22) on said layer (16, 17) of intrinsic hydrogenated amorphous silicon.

13. Method of manufacturing a solar cell according to claim 11 or 12 wherein said step a) comprises providing a substrate (1) of crystalline silicon and a step of texturing said substrate (1).

14. Method of manufacturing a solar cell according to claim 13 wherein said step of texturing a substrate of crystalline silicon comprises a step of anisotropic wet-etching or dry-etching.

**15.** Method of manufacturing a solar cell according to any one of claims 11 to 14 wherein the step b), c) and/or d) comprises a step of chemical vapor deposition at a temperature below 400°C.

**16.** Method of manufacturing a solar cell according to claim 15 wherein the step b) comprises a step of plasma enhanced chemical vapor deposition or hot wire chemical vapor deposition, using a gas mixture of silicon-rich gas and a carbon-rich gas, with or without dihydrogen.

Fig.1
Prior art

Fig.2
Prior art

Fig.3

**Fig.4**

**Fig.5**

**Fig.6**

# Fig.7

# Fig.8

a. Providing a substrate of a crystalline semiconductor material, said substrate having at least one randomly textured surface

↓

b.Depositing a layer of intrinsic hydrogenated amorphous carbide-silicon alloy on said at least one randomly textured surface

↓

c.Depositing at least one layer of intrinsic hydrogenated amorphous silicon on said layer of intrinsic hydrogenated amorphous carbide-silicon alloy

# Fig.9

Europäisches
Patentamt

European
Patent Office

Office européen
des brevets

# EUROPEAN SEARCH REPORT

Application Number

EP 14 30 6825

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X<br>Y | WO 2013/186945 A1 (MITSUBISHI ELECTRIC CORP) 19 December 2013 (2013-12-19)<br>* abstract *<br><br>& US 2015/068594 A1 (NISHIYAMA AYA [JP] ET AL) 12 March 2015 (2015-03-12)<br>* figures 1,2,4-6 *<br>* paragraphs [0001], [0004] - [0005], [0046] - [0047], [0049] - [0066] * | 1-7,9,<br>11-16<br>1,8,10,<br>11,15,16 | INV.<br>H01L31/0747<br>H01L31/18<br>H01L31/068<br>H01L31/0224 |
| Y | JANZ S, SUWITO D, GLUNZ S W: "PASSIVATION MECHANISMS OF AMORPHOUS Si xC 1-x LAYERS ON HIGHLY DOPED AND TEXTURED Si SURFACES", THE COMPILED STATE-OF-THE-ART OF PV SOLAR TECHNOLOGY AND DEPLOYMENT : 22ND EUROPEAN PHOTOVOLTAIC SOLAR ENERGY CONFERENCE, EU PVSEC ; PROCEEDINGS OF THE INTERNATIONAL CONFERENCE, HELD IN MILAN, ITALY, 3 - 7 SEPTEMBER 2007, MUNICH : WIP-RENEWABLE ENERG,<br>3 September 2007 (2007-09-03),<br>XP040513271,<br>ISBN: 978-3-936338-22-5<br>* the whole document * | 1,11 | |
| X<br><br>Y | DE 10 2011 052480 A1 (ROTH & RAU AG [DE]) 14 February 2013 (2013-02-14)<br><br>* abstract; figure 1 *<br>* paragraphs [0004] - [0005], [0011] - [0015], [0017] - [0018], [0020] - [0026], [0030] * | 1-4,6-9,<br>11,12,<br>15,16<br>1,8,11 | |
| Y | US 2010/236613 A1 (LEE JONG-JAN [US] ET AL) 23 September 2010 (2010-09-23)<br>* abstract; figure 6 *<br>* paragraphs [0039], [0043] - [0046] * | 10 | |

**TECHNICAL FIELDS SEARCHED (IPC)**

H01L

-/--

| The present search report has been drawn up for all claims | | |
|---|---|---|
| Place of search<br>Berlin | Date of completion of the search<br>29 April 2015 | Examiner<br>Cichos, Anna |

EPO FORM 1503 03.82 (P04C01)

Europäisches
Patentamt

European
Patent Office

Office européen
des brevets

# EUROPEAN SEARCH REPORT

Application Number

EP 14 30 6825

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | US 2013/203210 A1 (UTO TOSHIHIKO [JP] ET AL) 8 August 2013 (2013-08-08) <br> * abstract * <br> * paragraphs [0001], [0011], [0017] - [0023], [0046] - [0048] * <br> ----- | 15,16 | |

TECHNICAL FIELDS
SEARCHED        (IPC)

The present search report has been drawn up for all claims

| Place of search | Date of completion of the search | Examiner |
|---|---|---|
| Berlin | 29 April 2015 | Cichos, Anna |

## ANNEX TO THE EUROPEAN SEARCH REPORT
## ON EUROPEAN PATENT APPLICATION NO.

EP 14 30 6825

This annex lists the patent family members relating to the patent documents cited in the above-mentioned European search report.
The members are as contained in the European Patent Office EDP file on
The European Patent Office is in no way liable for these particulars which are merely given for the purpose of information.

29-04-2015

| Patent document cited in search report | | Publication date | Patent family member(s) | | Publication date |
|---|---|---|---|---|---|
| WO 2013186945 | A1 | 19-12-2013 | CN 104350607 A | | 11-02-2015 |
| | | | US 2015068594 A1 | | 12-03-2015 |
| | | | WO 2013186945 A1 | | 19-12-2013 |
| DE 102011052480 | A1 | 14-02-2013 | CN 103748692 A | | 23-04-2014 |
| | | | DE 102011052480 A1 | | 14-02-2013 |
| | | | EP 2742538 A2 | | 18-06-2014 |
| | | | TW 201312778 A | | 16-03-2013 |
| | | | WO 2013021298 A2 | | 14-02-2013 |
| US 2010236613 | A1 | 23-09-2010 | JP 2010219527 A | | 30-09-2010 |
| | | | US 2010236613 A1 | | 23-09-2010 |
| US 2013203210 | A1 | 08-08-2013 | US 2013203210 A1 | | 08-08-2013 |
| | | | WO 2012050186 A1 | | 19-04-2012 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **S. OLIBET ; C. MONACHON ; A. HESSLER-WYSER ; E. VALLAT-SAUVAIN ; S. DE WOLF ; L. FESQUET ; J. DAMON-LACOSTE ; C. BALLIF.** Textured silicon heterojunction solar cells of over 700 mV open-circuit voltage studied by transmission electron microscopy. *Proc. of the 23rd EU PV Conference,* 2008, 1140

- **TAGUCHI et al.** 24.7% Record Efficiency HIT Solar Cell on Thin Silicon Wafer. *IEEE Journal of Photovoltaics,* January 2014, vol. 4 (1), 96-99
- **D. PYSCH ; M. BIVOUR ; M. HERMLE ; S. W. GLUNZ.** Amorphous silicon carbide heterojunction solar cells on p-type substrates. *Thin Solid Films,* February 2011, vol. 519 (8), 2550-2554